# EUROPEAN PATENT APPLICATION

(11) **EP 0 865 077 A1**
(43) Date of publication of application: **16.09.1998**
(21) Application number: 97870037.5
(22) Date of filing: 14.03.1997
(51) Int. Cl.: H01L 21/285, C23C 14/34, H01L 31/108, C23C 14/16

(54) **Method for the formation of a thin metal silicide layer on a Si substrate, and use thereof in detector applications**

(71) Applicant: INTERUNIVERSITAIR MICRO-ELEKTRONICA CENTRUM VZW, 3001 Heverlee (BE)
(72) Inventor: Donaton, Ricardo Alves, 3001 Heverlee (BE); Bender, Hugo, 2650 Edegem (BE); Maex, Karen Irma Josef, 3020 Herent (BE)
(74) Representative: Van Malderen, Joelle

(57) **Abstract**

A method for the formation of thin homogeneous metal silicide layers on a silicon substrate, comprising the steps of:
- depositing under high vacuum conditions a metal layer on said substrate, thereby forming a first structure; thereafter
- etching said first structure in an etchant solution, said solution selectively etching said metal thereby forming a second structure; and thereafter
- heating said second structure for a time period at a temperature higher than about 350°C thereby forming said metal silicide layer.

## Description

### Filed of the invention

The present invention is related to a method for the formation of a thin metal silicide layer such as PtSi layer on a Si substrate. The present invention is also related to the use of said method for the fabrication of infrared detectors.

### Background of the invention

The process step of forming a silicide layer on a silicon substrate has been widely used and studied in silicon integrated (IC) manufacturing. Two of the more frequently used silicides are TiSi₂ and CoSi₂.

US-A-3661747 discloses a method for the formation of silicides wherein during RF sputter deposition of the metal on a silicon substrate, a silicide is builded up. An in-situ etching/cleaning method is disclosed based on ion bombardment of the substrate. By properly adjusting the rate of sputtering and etching, any metal which does not react is immediately etched away while the silicides build up because they are more etch resistant than the loosely bound unreacted metal. US-A-3661747 discloses the use of voltages of the order 4000 Volts to achieve the purpose of producing excellent platinum silicide contacts. Voltages below 3000 Volts result merely in the deposition of a platinum film on the silicon substrate.

US-A-4551908 discloses a method for the formation of silicide layers wherein after sputter deposition of the metal on a silicon substrate the resulting metal/silicon structure is intermixed by ion bombardment. Thereafter, a heating step with temperature in the range of 400°C to 650°C is performed in order to form a silicide. The formation of silicide layers with a thickness of about 1000 Å is disclosed.

US-A-4647361 discloses a method for the formation of silicide layers on a silicon substrate wherein the metal is deposited on a silicon wafer that is maintained at a temperature of about 350-550°C or even higher. The in-situ formation of silicide layers with a thickness of 300-800 Å is disclosed.

US-A-5401677 discloses a method for the formation of silicide layers on a silicon substrate comprising the steps of DC sputter depositing the metal on said substrate and thereafter heating the metal/silicon structure. It is also a part of the teaching of US-A-5401677 that the as-deposited metal is in a distinct layer having no discernible reaction with silicon.

Among other applications known in the art, the use of Silicide/silicon Schottky barrier junctions for infrared detector applications is known. For a good infrared detector behaviour the metal silicide layer of the silicide/silicon Schottky barrier junction has to be thin, with a thickness in the range of 2 to 8 nm.

A control of the uniformity and of the thickness of the silicide layer is critical for this application and for other applications wherein thin silicide layers are used.

In the sequel of the present text, it is to be understood that thin layers are layers with a thickness in the range of 2 to 10 nm.

An example of such silicide/silicon Schottky barrier junctions are PtSi/Si junctions. PtSi has a Schottky barrier height to p-type Si of about 0.23 eV and is one of the most used silicides in infrared Schottky barrier detectors (IRSBD), despite of its low quantum efficiency.

Besides, PtSi can be formed on silicon in a self-aligned way. This means that when platin is deposited on a silicon wafer, the surface of which is partly covered with a dielectric such as silicon oxide (e.g. SiO₂) or silicon nitride, during thermal treatment the metal (Pt) reacts with Si but not with silicon oxide, and an alignment of the silicide with the edges of the dielectric is achieved. The unreacted metal (on those parts of the wafer surface covered with dielectric) is then removed by a selective wet etch.

Thin PtSi films are usually fabricated by ultra-high vacuum (UHV) e-beam evaporation of Pt on a heated substrate. A subsequent furnace heating at temperatures of 450 - 550^{o}C for about 30 minutes is used to form the silicide. Thereafter, a selective etch is performed to remove the unreacted Pt. Silicide layers with a thickness of 2 to 3 nm can be formed in this way. The controllability of the metal thickness during deposition of thin layers is one difficulty of this process. Other drawbacks of this technique are the cost of the UHV systems and the fact that these systems have a low throughput and are not commonly available in a standard silicon IC production environment.

A new method for forming layers of PtSi based on sputter deposition of the metal and on a two-step Rapid Thermal Processing (RTP) process has been proposed in document EP-A-0751577. This document addresses the problem of defining a process sequence, compatible with standard silicon processing techniques that yields thin continuous PtSi layers on a silicon substrate. The major problem associated with the method disclosed in EP-A-0751577 is the controllability of the temperature of the first RTP step which is a crucial step in the process.

Disadvantages of the prior art production techniques or process sequences for the production of thin metal silicide/silicon junctions include the following disadvantages.

One disadvantage is that most prior art process sequences require ultra high vacuum systems with working pressure of the order of 10-7 to 10-9 mbar or lower for deposition of the metal layers on silicon. Such ultra-high vacuum systems are expensive, have a low throughput and are not commonly available in a standard silicon IC processing environment.

Another disadvantage of the prior art production techniques or process sequences is that for the subsequent step of heating the metal/silicon structure after deposition of the metal on a silicon wafer, a conventional furnace is used. Such furnaces require long heating times and therefore a relatively high level of contamination is introduced in the heated silicide/silicon structures.

### Aim of the present invention

The prior art does not disclose a method for forming thin silicide layers on a silicon substrate wherein the method relies on a sequence of process steps which are compatible with standard silicon IC processing and which allows a relatively broad processing window wherein none of the processing steps being dependent on a process parameter, a precise control of which being critical.

### Summary of the invention

The present invention is related to a method for the formation of continuous and uniform thin metal silicide layers with a thickness within the range of 2 to 10 nm and more preferably from 2 to 5 nm, based on sputtering deposition of the metal, followed by a selective wet etch and a rapid thermal processing (RTP) step.

More particularly, the method comprises the following steps:
- depositing under high vacuum conditions a metal layer on said substrate, thereby forming a first structure; thereafter
- etching said first structure in an etchant solution, said solution selectively etching said metal thereby forming a second structure ; and thereafter
- heating said second structure for a time period at a temperature higher than about 305°C thereby forming said metal silicide layer.

Sputtering deposition systems have the characteristics of being production like tools which do not require UHV, which have high deposition rates and which are compatible with standard silicon processing technologies.

According to the method of the invention, the thickness of the silicide formed is independent of the thickness of the as-deposited metal. It is determined by the thickness of an intermixed layer of metal and Si possibly formed at the metal/Si interface during deposition of the metal on the silicon substrate. Small variations in the process conditions during sputter deposition of the metal do not affect the structure of the final metal silicide/silicon junction. Thus, a relatively broad processing window for metal deposition is obtained.

After deposition, a selective wet etch removes the metal layer but, thus, does not attack the metal-Si intermixed layer. Subsequently, a heating step by rapid thermal processing is performed. The advantages of rapid thermal processing (RTP) are the short processing time and therefore a low contamination level is introduced during said heating step. A relatively broad range of temperatures can be used in this process step, and therefore, the controllability of the temperature is not a major issue and a broad processing window is obtained.

The uniform and thin PtSi layers formed according to this method are suitable for the integration in the fabrication process of metal silicide/silicon junctions for used in infrared detectors of infrared Schottky barrier diodes (IRSBD).

### Brief description of the drawings

**Figure 1** shows a schematic drawing of the process sequence for the formation of PtSi/Si junctions according to a preferred embodiment of the invention.

**Figure 2** shows a high resolution cross-section transmission electron microscopy (H-XTEM) image of a PtSi layer on a silicon substrate formed using this method used.

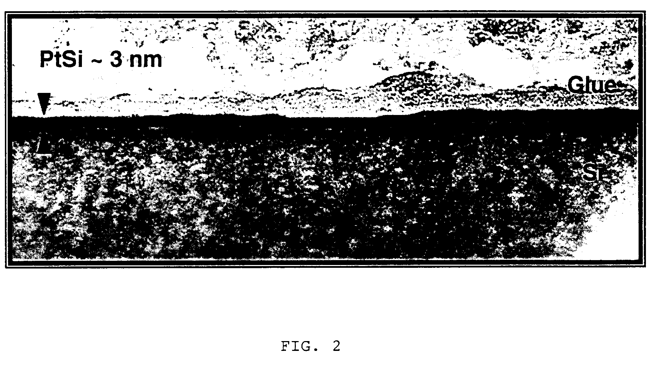

The glue for the preparation of the PtSi/Si structures for TEM analysis is visible in figure 2 as well.

### Detailed description of preferred embodiments of the present invention

As a preferred embodiment of the present invention, a processing sequence is disclosed for the fabrication of PtSi/Si Schottky barrier junctions having a thin PtSi layer. The process sequence according to the method of the invention however can also be used to fabricate other metal silicide/silicon junctions wherein the metal can be a near noble metal such as Cobalt, Nickel, Palladium or Titanium or another metal that can react with silicon to form a metal silicide. In this preferred embodiment of the invention, the formation of ultra-thin layers of PtSi is obtained for 6 inch n-type Si (100) wafers, having a resistivity in the range of 10-30 Ωcm.

The silicon wafers according to the preferred embodiment are manufactured by WACKER. The wafers are cleaned using a standard RCA cleaning. Other cleaning methods such as the IMEC-CLEAN™ method or variants on the standard RCA cleaning sequence can be used as well.

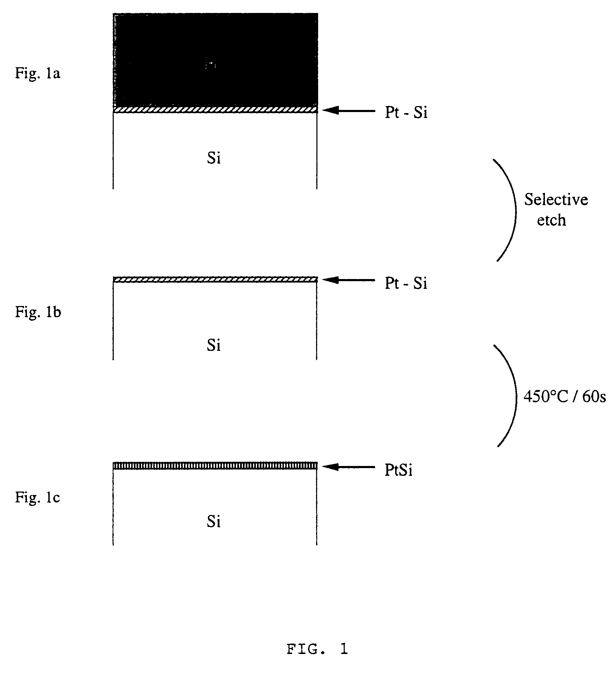

The native oxide on the wafers need to be removed before deposition of the metal. Therefore, the wafers can receive a quick dip (30 seconds) in a HF 2% solution to remove the native oxide just before loading them into a sputtering chamber. In this preferred embodiment, a high vacuum DC magnetron sputtering system is used to deposit a thick layer of Pt. The base pressure achieved by the system is around 5 x 10⁻⁶ mbar. Sputter power values in between 0.5 and 1.75 kW (nominal values) can be used. The target voltages are 550 and 630 V for sputter power values of 0.5 and 1.75 kW respectively. Pt layers with thicknesses in the range of 25 to 300 nm or higher can be deposited (figure 1a).

The selective etch (figure 1b) used to remove the deposited Pt can be a solution of H₂O (1200 ml) / HCl (690 ml) / HNO₃ (90 ml) used at 85°C. It is possible to use as an etching solution also a mixture of acetic acid (800 ml)/HCl (460 ml)/HNO₃ (60 ml) at 85°C. In general, a mixture comprising HCl and HNO₃ can be used within a range of etching temperatures. The etching time is dependent on the temperature at which the etching step is performed and on the thickness of the deposited Pt layer. For instance, the etching time can vary from 3 minutes to 7 minutes, depending on the Pt thickness. After the wafers are taken out of the etchant solution, the wafers are loaded in a rapid thermal processing system (RTP) and are heated preferably at 450°C for 60 seconds in a non-reactive gas ambient such as N₂ or Argen. The rapid thermal processing (RTP) step can be performed at temperatures in the range of 300°C - 700°C, preferably in the range of 400°C - 600°C, preferably in the range of 450°C - 550°C and even preferably around 450°C during typically a range from a few seconds to a few minutes to promote the reaction of Pt and Si in order to form the PtSi layer (Fig. 1c).

During the RTP step at 450 °C the Pt present in the intermixed layer will react with Si to form PtSi. The temperature window for this step of the process is relatively wide, varying from about 400°C to about 600°C. Therefore, the temperature control, which is an important issue in prior art processes, is not critical in the method according to the invention.

X-ray diffraction and high resolution transmission electron microscopy (H-TEM) can be used to characterise the layers formed.

In an analysis of PtSi/Si junctions being fabricated according to the preferred embodiment of the present invention, X-ray diffraction (XRD) was used to identify the phases present in the layers after each processing step. Analyses of different wafers were done in a θ/2θ (or symmetric) geometry and also with a grazing angle of incidence (GXRD) of 2°. It is important to note that the silicides prepared under different sputtering conditions show the same characteristics. The as-deposited wafers showed for the two geometries (θ/2θ and GXRD configurations), that only Pt is present in the layer. This Pt layer is (111) textured. In the θ/2θ geometry only Si peaks were observed after etching and after RTP heating. In the GXRD analysis of the wafers after etching only peaks attributed to the silicon substrate are observed. However, after annealing at 450 °C for 60 seconds in the GXRD analysis peaks which can be assigned to PtSi can be seen. These peaks are broad and have low intensity, resulting from a extreme thin layer with small grain size.

These results are in agreement with the hypotheses that an intermixed Pt-Si layer formed during deposition is left after the selective etch. The fact that this layer may be a layer without crystalline structure can explain why no diffraction peaks are observed in the GXRD spectrum. This layer is then converted to PtSi after the RTP step, as confirmed by the presence of diffraction peaks corresponding to this silicide phase.

Cross-section transmission electron microscopy (X-TEM) was used to evaluate the thickness, uniformity and silicide/Si interface quality of the layers formed according to the process sequence of the preferred embodiment of the present invention. Wafers after each step were characterised. It was noticed that the TEM wafer preparation causes changes in the structure of the wafer as-deposited and after etching. This may be due to the fact that Pt and Si react at low temperatures and during TEM preparation of the wafers for TEM analysis, the temperature may exceed 110°C. Therefore, the characterisation was concentrated on the wafers after the RTP step. It is observed that PtSi layers with thickness of about 3 - 4 nm are formed after RTP. These layers are uniform, smooth and have a sharp silicide/Si interface (Fig. 2). The silicide layers formed from different sputtering conditions have the same characteristics, thus indicating that the layers formed are not very sensitive to the sputtering conditions.

Although direct proof of the presence of the intermixed Pt-Si layer formed during deposition has not been found, the results obtained after the whole process support this idea. It may be explained as follows. During the sputtering deposition process the sputtered atoms reach the substrate with a certain energy, normally in the range of 5 to 50 eV. Heavy atoms, like Pt, can be implanted into the substrate during deposition. The depth range of this implanted atoms is in the order of few angstroms. The presence of an intermixed, or amorphous, layer after metal deposition may be assumed.

The selective etch solution removes Pt at a fast rate. The etch rate is strongly slowed down when the intermixed Pt-Si layer is reached. The etching solution used is an oxidising solution. When the Pt-Si layer is exposed, Si can be oxidised forming SiO₂, stopping the reaction. Another possible mechanism for the observed etching selectivity is that Pt is intermixed with Si in the intermixed layer, thus not being completely free to be easily removed.

## Claims

1. A method for the formation of thin homogeneous metal silicide layers on a silicon substrate, comprising the steps of:
- depositing under high vacuum conditions a metal layer on said substrate, thereby forming a first structure; thereafter
- etching said first structure in an etchant solution, said solution selectively etching said metal thereby forming a second structure ; and thereafter
- heating said second structure for a time period at a temperature higher than about 350°C thereby forming said metal silicide layer.

2. The method as recited in claim 1, wherein said time period is less than five minutes.

3. The method as recited in claim 2, wherein said heating step is performed in a rapid thermal processing system.

4. The method as recited in claim 1, wherein said deposition step is performed by sputter depositing said metal layer on said substrate.

5. The method as recited in claim 4, wherein said temperature is lower than 700°C.

6. The method as recited in claim 5, wherein said temperature is around 450°C.

7. The method as recited in claim 4, wherein said first structure comprises an intermixed layer in between said substrate and said metal layer comprising silicon atoms and metal atoms.

8. The method as recited in claim 7, wherein said etchant is etching substantially slower said intermixed layer than said metal, thereby defining a time window for said etching step wherein said second structure can be taken out from said etchant and said second structure comprises at least a part of said intermixed layer.

9. The method as recited in claim 8, wherein said etchant comprises HCl.

10. The method as recited in claim 9, wherein said etchant further comprises HNO₃.

11. The method as recited in claim 8, wherein said metal is one metal of the group of near-noble metals.

12. The method as recited in claim 8, wherein said metal is Co, Ti, Ni or Pd.

13. The method as recited in claim 8, wherein said metal is platinum and said silicide is PtSi.

14. The method as recited in claim 13, wherein said PtSi layer has a thickness in the range of 2 to 5 nm.

15. Use of the method as recited in any one of the preceding claims for forming metal silicide/silicon Schottky barrier junctions for use in an infrared radiation detector.
